# EUROPEAN PATENT SPECIFICATION

(11) **EP 4 012 766 B1**
(45) Date of publication and mention of the grant of the patent: **08.05.2024**
(21) Application number: 21213301.1
(22) Date of filing: 09.12.2021
(51) Int. Cl.: H01L 25/075, F21Y 115/10, F21Y 105/12, F21Y 105/18, F21Y 113/13

(54) **FULL-COLOR CHIP-ON-BOARD (COB) DEVICE**
VOLLFARBEN-CHIP-ON-BOARD (COB)-VORRICHTUNG
DISPOSITIF DE PUCE SUR PLAQUE À PLEINE COULEUR

(30) Priority: 11.12.2020 CN 202011438186
(43) Date of publication of application: 15.06.2022
(73) Proprietor: Foshan Evercore Optoelectronic Technology Co.,Ltd., Foshan City Guangdong Province 528225 (CN)
(72) Inventor: WANG, Mengyuan, Foshan (CN); ZENG, Weiqiang, Foshan (CN); DONG, Tingbo, Foshan (CN); HUANG, Chaoming, Foshan (CN)
(74) Representative: Sun, Yiming

(56) References cited:
- CN-B- 105 261 613
- CN-U- 202 275 828
- CN-U- 211 507 628
- US-A1- 2012 091 480
- US-A1- 2012 099 303
- US-A1- 2015 228 629

## Description

### TECHNICAL FIELD

The present invention relates to the technical field of chip-on-board (COB) light sources, and in particular, to a full-color COB device.

Specifically, the invention relates to a full-color chip-on-board device as defined in claim 1 attached.

### BACKGROUND

Most red green blue (RGB) dimming light emitting diode (LED) light sources on the market are generally bulb lights and panel lights. These light sources can only be used for flood lighting, while commercial lighting generally requires that light sources have small light-emitting surfaces. COB devices have an essential advantage of power density when being applied to commercial lighting, and may have small light-emitting surfaces with the same power, which is conducive to secondary optics design. Currently, although there are also RGB dimming COB devices and COB devices with adjustable cold light and warm light on the market, the white light mixing effect of an existing RGB dimming COB device is poor, and the adjustable color gamut range of an existing COB device with adjustable cold light and warm light is narrow. The above two types of dimming COB devices cannot satisfy the market requirement of high-end commercial lighting.

In the prior art, there is also a COB light source integrated with a RGB dimming chip and a cold and warm light dimming chip. However, in this COB light source, an RGB light-emitting region is generally located in the middle of a global light-emitting region, and a cold and warm light-emitting region is generally located at the edge of the global light-emitting region. When the RGB light-emitting region occupies a small area, impact on flare of white light is not obvious, but RGB power is excessively small and the dimming function cannot be fully performed. When the RGB light-emitting region occupies a large area and only white light illuminates, a light-emitting surface in the middle of the COB light source is a dark area, and secondary optical processing has a large impact on flare of the white light.

Document CN 105 261 613 B discloses an LED light source component, the LED light source component includes a substrate, a first level cold white LED chip, a first level red LED chip, a first level green LED chip, a first level blue LED chip and a first level warm white LED chip; the first level cold white LED chip, the first level red LED chip, the first level green LED chip, the first level blue LED chip and the first level warm white LED chip are all arranged on the substrate; the first level cold white LED chip is located in the middle of the substrate; the first level red LED chip, the first level green LED chip and the first level blue LED chip are alternately surrounded into a first level RGB color ring structure; the first level RGB color ring structure is located at the periphery of the first level cold white LED chip; the first level warm white LED chip is in a ring structure, which is located at the periphery of the first level RGB color ring structure; the first level cold white LED chip, the first level RGB color ring structure and the first level warm white LED chip are located on a coaxial line.

Document CN 211 507 628 U discloses an LED light source device, the LED light source device includes a substrate and a plurality of LED packaging modules arranged on the substrate; the substrate includes a central area and at least one layer of annular area surrounding the central area. At least one of the plurality of LED packaging modules is installed in the central area of the substrate, and the remaining LED packaging modules are installed in at least one annular area of the substrate, wherein the LED packaging module includes a packaging substrate and a plurality of LED chips, the plurality of LED chips are installed on the packaging substrate and arranged in an array, and the plurality of LED chips include at least five color chips.

Document US 2012/0099303 A1 discloses a correlated color temperature (CCT) modulating method, wherein a white LED light source is modulated to emit a first white light. At least one LED light source is modulated to emit a second white light, wherein the second white light includes at least one broad-spectrum monochromatic light. The first white light and the second white light are mixed to produce a third white light. The color rendering index (CRI) of the third white light is greater than those of the first white light and the second white light, and the color coordinates of the first white light, the second white light, and the third white light are different from each other.

CN 202 275 828 U discloses a colour temperature adjustable white LED integrated packaging structure comprising LED chip groups that are coated with fluorescent powder coating layers to form different package regions.

### SUMMARY

The objective of the present invention is to propose a full-color COB device. The COB device has a small light-emitting region, but has a wide adjustable color range and a desirable light mixing effect, which helps to overcome the shortcomings in the prior art. In order to achieve the above objective, the present invention adopts the technical solution as defined in claim 1 as attached. Preferred embodiments of the invention are defined in claims as attached and dependent upon claim 1.

The present invention has the following beneficial effects:
1. In this technical solution, the atmosphere lighting region encloses the white light-emitting region. Compared with the prior art, the flare effect formed by the white light-emitting region is not affected while the high-power atmosphere lighting region is implemented. In addition, this facilitates subsequent optical processing.
2. In this technical solution, a plurality of warm light-emitting modules and a plurality of cold light-emitting modules are disposed in the white light-emitting region, and the warm light-emitting module and the cold light-emitting module are disposed in a staggered manner. This helps to improve the effect of mixing cold light and warm light, thereby further facilitating subsequent optical processing.
3. In this technical solution, a plurality of red light-emitting modules, a plurality of green light-emitting modules, and a plurality of blue light-emitting modules are disposed in the atmosphere lighting region, and the red light-emitting modules, the green light-emitting modules, and the blue light-emitting modules are disposed in a staggered manner. This helps to ensure that light emitted by the atmosphere lighting region is evenly mixed in color after optical processing.

### BRIEF DESCRIPTION OF THE DRAWINGS

The accompanying drawings further describe embodiments of the present invention. However, the contents in the accompanying drawings do not form any limit to the present invention.
FIG. 1 is a structural schematic diagram of an embodiment of a full-color COB device according to the present invention;
FIG. 2 is a structural schematic diagram of an embodiment of a full-color COB device according to the present invention;
FIG. 3 is a structural schematic diagram of an embodiment of a full-color COB device according to the present invention; and
FIG. 4 is a structural schematic diagram of an embodiment of a full-color COB device according to the present invention.

Substrate 1, white light-emitting region 101, warm light-emitting module 11, cold light-emitting module 12, atmosphere lighting region 102, red light-emitting module 13, green light-emitting module 14, blue light-emitting module 15, dam 16, pad 17, and fast wiring terminal 18.

### DETAILED DESCRIPTION

The technical solutions of the present invention will be further described below in detailed implementations with reference to the accompanying drawings.

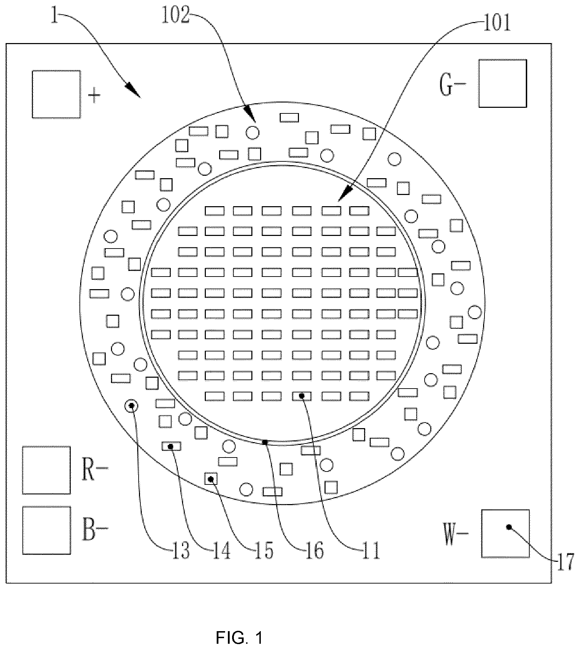

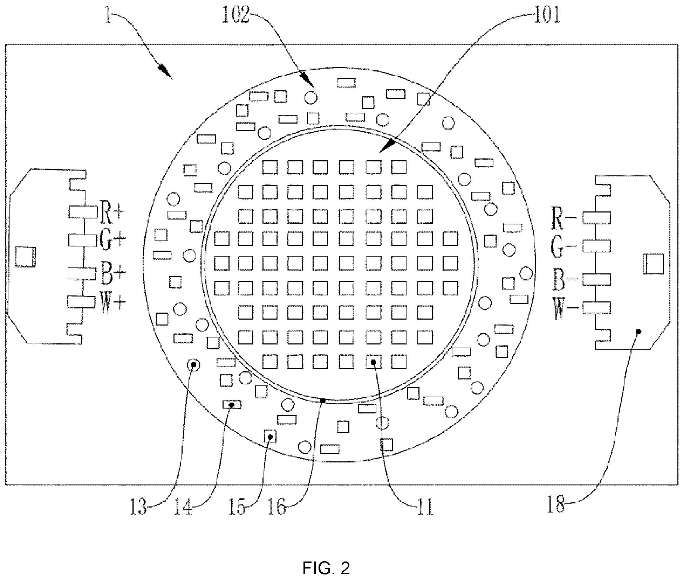

As shown in FIG. 1 and FIG. 2, a full-color COB device includes a substrate 1, where a light-emitting region is provided on an upper surface of the substrate 1, the light-emitting region includes a white light-emitting region 101 and an atmosphere lighting region 102, the atmosphere lighting region 102 is a closed ring-shaped structure, and the atmosphere lighting region 102 encloses the white light-emitting region 101.

A plurality of red light-emitting modules 13, a plurality of green light-emitting modules 14, and a plurality of blue light-emitting modules 15 are disposed in the atmosphere lighting region 102, and the red light-emitting modules 13, the green light-emitting modules 14, and the blue light-emitting modules 15 are disposed in a staggered manner.

Most RGB dimming LED light sources on the market are generally bulb lights and panel lights. These light sources can only be used for flood lighting, while commercial lighting generally requires that light sources have small light-emitting surfaces. COB devices have an essential advantage of power density when being applied to commercial lighting, and may have small light-emitting surfaces with the same power, which is conducive to secondary optics design. Currently, although there are also RGB dimming COB devices and COB devices with adjustable cold light and warm light on the market, the white light mixing effect of an existing RGB dimming COB device is poor, and the adjustable color gamut range of an existing COB device with adjustable cold light and warm light is narrow. The above two types of dimming COB devices cannot satisfy the market requirement of high-end commercial lighting.

In the prior art, there is also a COB light source integrated with a RGB dimming chip and a cold and warm light dimming chip. However, in an existing COB light source, an RGB light-emitting region is generally located in the middle of a global light-emitting region, and a light-emitting region of a cold and warm light-emitting region is generally located at the edge of the global light-emitting region. When the RGB light-emitting region occupies a small area, impact on flare of white light is not obvious, but RGB power is excessively small and the dimming function cannot be fully performed. When the RGB light-emitting region occupies a large area and only white light illuminates, a light-emitting surface in the middle of the COB light source is a dark area, and secondary optical processing has a large impact on flare of the white light.

To resolve the technical problem of the existing RGB dimming COB light source, this technical solution proposes a full-color COB device. The COB device has a small light-emitting region, but has a wide adjustable color range and a desirable light mixing effect. Specifically, the full-color COB device includes a substrate 1, where a light-emitting region is provided on an upper surface of the substrate 1, the light-emitting region includes a white light-emitting region 101 and an atmosphere lighting region 102, the atmosphere lighting region 102 is a closed ring-shaped structure, and the atmosphere lighting region 102 encloses the white light-emitting region 101. Because the atmosphere lighting region 102 mainly serves to assist the atmosphere in the full-color COB light source, it is required that power of the atmosphere lighting region 102 cannot be excessively low, and at the same time, cannot affect the lighting effect of the white light-emitting region 101. It is required that the white light-emitting region 101 has a desirable flare effect, flare brightness and color cannot be uneven during dimming, and the like. Therefore, in this technical solution, the atmosphere lighting region 102 encloses the white light-emitting region 101. The flare effect formed by the white light-emitting region 101 is not affected while the high-power atmosphere lighting region 102 is implemented. In addition, because the optical processing, especially light concentrating processing, of the COB light source requires a concentrated focus. If the white light-emitting region that needs to be processed is not sufficiently concentrated, it is difficult to perform optical processing on the white light-emitting region. Therefore, in this technical solution, the white light-emitting region 101 is located in the middle of the light-emitting region, which is more conducive to subsequent optical processing.

Further, in this technical solution, a plurality of red light-emitting modules 13, a plurality of green light-emitting modules 14, and a plurality of blue light-emitting modules 15 are disposed in the atmosphere lighting region 102, and the red light-emitting modules 13, the green light-emitting modules 14, and the blue light-emitting modules 15 are disposed in a staggered manner. This helps to ensure that light emitted by the atmosphere lighting region 102 is evenly mixed in color after optical processing.

Preferably, in this technical solution, the full-color COB device further includes a pad 17 or a fast wiring terminal 18, the pad 17 or the fast wiring terminal 18 is mounted on the upper surface of the substrate 1, and the light-emitting module is electrically connected to a drive power supply through the pad 17 or the fast wiring terminal 18.

Preferably, the substrate 1 is a metal substrate or a ceramic substrate. In an embodiment of this technical solution, the substrate 1 is a metal substrate or a ceramic substrate, and the type of the substrate 1 can be specifically selected according to the actual need. The metal substrate helps to improve the heat dissipation effect of the COB device, and can effectively avoid that heat accumulation affects the service life of the COB device.

Further, an area of the white light-emitting region 101 occupies 15% to 70% of that of the light-emitting region area according to an area percentage.

In an embodiment of this technical solution, the area of the white light-emitting region 101 occupies 15% to 70% of that of the light-emitting region area according to an area percentage. The size of the area of the white light-emitting region 101 affects the quality of the flare effect formed by the white light-emitting region 101. Therefore, to ensure that the full-color COB device in this technical solution emits flare with a desirable effect, the ratio of the area of the white light-emitting region 101 to that of the light-emitting region is limited to 15% to 70% in this technical solution.

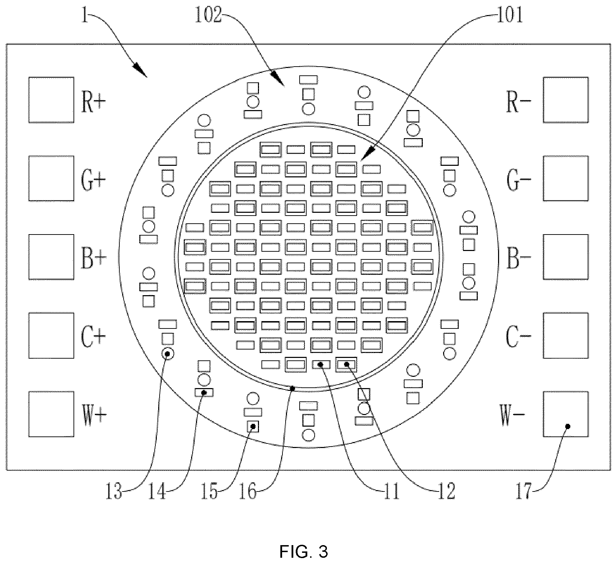

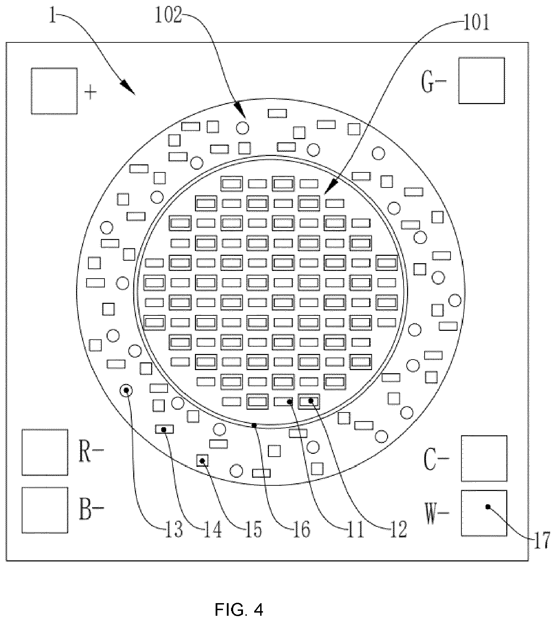

Further, as shown in FIG. 3 and FIG. 4, a plurality of warm light-emitting modules 11 and a plurality of cold light-emitting modules 12 are disposed in the white light-emitting region 101, and the warm light-emitting module 11 and the cold light-emitting module 12 are disposed in a staggered manner.

Further, in this technical solution, a plurality of warm light-emitting modules 11 and a plurality of cold light-emitting modules 12 are disposed in the white light-emitting region 101, and the warm light-emitting module 11 and the cold light-emitting module 12 are disposed in a staggered manner. This helps to improve the effect of mixing cold light and warm light, thereby further facilitating subsequent optical processing.

Further, the warm light-emitting module 11 is a low color temperature CSP chip, and a color temperature range of the low color temperature CSP chip is 1800K to 3500K.

Further, the cold light-emitting module 12 is a high color temperature CSP chip, a color temperature of the high color temperature CSP chip is higher than that of the low color temperature CSP chip, and a color temperature range of the high color temperature CSP chip is 3000K to 8000K.

Further, the cold light-emitting module 12 includes an LED chip and a fluorescent glue layer, and the fluorescent glue layer covers a top of the LED chip.

Further, the fluorescent glue layer is a mixture of silica gel and phosphor, a color temperature of the phosphor is higher than that of the low color temperature CSP chip, and a color temperature range of the phosphor is 3000K to 8000K.

Further, the full-color COB device further includes a dam 16, where the dam 16 protrudes from the upper surface of the substrate 1, and the dam 16 is located between the white light-emitting region 101 and the atmosphere lighting region 102.

In an embodiment of this technical solution, the cold light-emitting module 12 may be a high color temperature CSP chip. In another embodiment of this technical solution, the cold light-emitting module 12 may include an LED chip and a high color temperature fluorescent glue layer. When the cold light-emitting module 12 includes an LED chip and a high color temperature fluorescent glue layer, to prevent fluorescent glue from covering the red light-emitting module 13, the green light-emitting module 14, and the blue light-emitting module 15 in the atmosphere lighting region 102 during dispensing, the dam 16 is further disposed in the full-color COB device in this technical solution. The dam 16 protrudes from the upper surface of the substrate 1, and is located between the white light-emitting region 101 and the atmosphere lighting region 102. The disposed dam 16 effectively separates the white light-emitting region 101 from the atmosphere lighting region 102, to effectively prevent the light-emitting module in the atmosphere lighting region 102 from being excited by the high color temperature fluorescent glue layer and changing in color.

Further, the red light-emitting module 13 is a red LED chip, the green light-emitting module 14 is a green LED chip, the blue light-emitting module 15 is a blue LED chip, and the red LED chip, the green LED chip, and the blue LED chip may be any one of a face-up LED chip, a flip LED chip, or a vertical LED chip.

In an embodiment of this technical solution, the red LED chip, the green LED chip, and the blue LED chip may be any one of a face-up LED chip, a flip LED chip, or a vertical LED chip, which may be selected according to actual needs.

Further, the full-color COB device further includes a package layer, where the package layer is configured to cover the light-emitting region.

In an embodiment of this technical solution, the package layer in this technical solution may be a transparent silicone layer or a slightly milky white glue layer with a diffusion effect, which may be selected according to actual needs.

The technical principles of the present invention are described above with reference to the specific embodiments. These descriptions are merely intended to explain the principles of the present invention, and may not be construed as limiting the protection scope of the present invention in any way. The invention is defined by the appended claims.

## Claims

1. A full-color chip-on-board (COB) device, comprising a substrate (1), wherein a light-emitting region is provided on an upper surface of the substrate (1), the light-emitting region comprises a white light-emitting region (101) and an atmosphere lighting region (102), and the atmosphere lighting region (102) is a closed ring-shaped structure; and a plurality of red light-emitting modules (13), a plurality of green light-emitting modules (14), and a plurality of blue light-emitting modules (15) are disposed in the atmosphere lighting region (102), wherein
the white light-emitting region (101) is only one white light-emitting region (101), and
the atmosphere lighting region (102) is only one atmosphere lighting region (102);
the only one atmosphere lighting region (102) encloses the only one white light-emitting region (101); and the red light-emitting modules (13), the green light-emitting modules (14), and the blue light-emitting modules (15) are disposed in a staggered mannerto ensure that light emitted by the only one atmosphere lighting region (102) is evenly mixed in color,
a plurality of warm light-emitting modules (11) and a plurality of cold light-emitting modules (12) are disposed in the only one white light-emitting region (101), and the warm light-emitting modules (11) and the cold light-emitting modules (12) are disposed in a staggered manner to improve the effect of mixing cold light and warm light,
each warm light-emitting module (11) is a low color temperature chip scale package (CSP) chip, and a color temperature range of the low color temperature CSP chip is 1800K to 3500K, and
each cold light-emitting module (12) is a high color temperature CSP chip, a color temperature of the high color temperature CSP chip is higher than that of the low color temperature CSP chip, and a color temperature range of the high color temperature CSP chip is 3000K to 8000K, or
each cold light-emitting module (12) comprises a light emitting diode (LED) chip and a fluorescent glue layer, and the fluorescent glue layer covers a top of the LED chip,
wherein the fluorescent glue layer is a mixture of silica gel and phosphor, a color temperature of the phosphor is higher than that of the low color temperature CSP chip, and a color temperature range of the phosphor is 3000K to 8000K, and
a dam (16) protrudes from the upper surface of the substrate (1), and the dam (16) is located between the only one white light-emitting region (101) and the only one atmosphere lighting region (102) to effectively separate the only one white light-emitting region (101) from the only one atmosphere lighting region (102).

2. The full-color COB device according to claim 1, wherein an area of the white light-emitting region (101) occupies 15% to 70% of that of the light-emitting region area according to an area percentage.

3. The full-color COB device according to claim 1, wherein each red light-emitting module (13) is a red LED chip, each green light-emitting module (14) is a green LED chip, each blue light-emitting module (15) is a blue LED chip, and the red LED chip, the green LED chip, and the blue LED chip each are any one of a face-up LED chip, a flip LED chip, or a vertical LED chip.

4. The full-color COB device according to claim 1, further comprising a package layer, wherein the package layer is configured to cover the light-emitting region.

## Patentansprüche

1. Vollfarben-Chip-on-Board-(COB-)Vorrichtung, umfassend ein Substrat (1), wobei ein lichtemittierender Bereich auf einer oberen Fläche des Substrats (1) bereitgestellt ist, wobei der lichtemittierende Bereich einen Weißlicht-emittierenden Bereich (101) und einen atmosphärischen Beleuchtungsbereich (102) umfasst, und der atmosphärische Beleuchtungsbereich (102) eine geschlossene ringförmige Struktur ist; und eine Vielzahl von Rotlicht-emittierenden Modulen (13), eine Vielzahl von Grünlicht-emittierenden Modulen (14) und eine Vielzahl von Blaulicht-emittierenden Modulen (15) in dem atmosphärischen Beleuchtungsbereich (102) angeordnet sind, wobei der Weißlicht-emittierende Bereich (101) ein einzelner Weißlicht-emittierender Bereich (101) ist, und
der atmosphärische Beleuchtungsbereich (102) ein einzelner atmosphärischer Beleuchtungsbereich (102) ist; der einzelne atmosphärische Beleuchtungsbereich (102) den einzelnen Weißlicht-emittierenden Bereich (101) umschließt; und die Rotlicht-emittierenden Module (13), die Grünlicht-emittierenden Module (14) und die Blaulicht-emittierenden Module (15) versetzt angeordnet sind, um sicherzustellen, dass das Licht, das von dem einzelnen atmosphärischen Beleuchtungsbereich (102) emittiert wird, gleichmäßig in der Farbe gemischt ist,
eine Vielzahl von Warmlicht-emittierenden Modulen (11) und eine Vielzahl von Kaltlicht-emittierenden Modulen (12) in dem einzelnen Weißlicht-emittierenden Bereich (101) angeordnet sind, und die Warmlicht-emittierenden Module (11) und die Kaltlicht-emittierenden Module (12) versetzt angeordnet sind, um den Effekt des Mischens von Kaltlicht und Warmlicht zu verbessern,
jedes Warmlicht-emittierende Module (11) ein Chip-Scale-Package-(CSP-)Chip mit niedriger Farbtemperatur ist und ein Farbtemperaturbereich des CSP-Chips mit niedriger Farbtemperatur 1800 K bis 3500 K beträgt, und
jedes Kaltlicht-emittierende Modul (12) ein CSP-Chip mit hoher Farbtemperatur ist, eine Farbtemperatur des CSP-Chips mit hoher Farbtemperatur höher als die des CSP-Chips mit niedriger Farbtemperatur ist und ein Farbtemperaturbereich des CSP-Chips mit hoher Farbtemperatur 3000 K bis 8000 K beträgt oder
jedes Kaltlicht-emittierende Modul (12) einen Leuchtdioden-(LED-)Chip und eine fluoreszierende Klebeschicht umfasst, wobei die fluoreszierende Klebeschicht eine Oberseite des LED-Chips abdeckt,
wobei die fluoreszierende Klebeschicht ein Gemisch aus Kieselgel und Leuchtstoff ist, die Farbtemperatur des Leuchtstoffs höher als die des CSP-Chips mit niedriger Farbtemperatur ist und der Farbtemperaturbereich des Leuchtstoffs 3000 K bis 8000 K beträgt, und
eine Schutzwand (16) von der oberen Fläche des Substrats (1) vorsteht, und die Schutzwand (16) zwischen dem einzelnen Weißlicht-emittierenden Bereich (101) und dem einzelnen atmosphärischen Beleuchtungsbereich (102) angeordnet ist, um den einzelnen Weißlicht-emittierenden Bereich (101) von dem einzelnen atmosphärischen Beleuchtungsbereich (102) effektiv zu trennen.

2. Vollfarben-COB-Vorrichtung nach Anspruch 1, wobei eine Fläche des Weißlicht-emittierenden Bereichs (101) 15% bis 70 % der Fläche des lichtemittierenden Bereichs gemäß einem Flächenanteil einnimmt.

3. Vollfarben-COB-Vorrichtung nach Anspruch 1, wobei jedes Rotlichtemittierende Modul (13) ein roter LED-Chip ist, jedes Grünlicht-emittierende Modul (14) ein grüner LED-Chip ist, jedes Blaulicht-emittierende Modul (15) ein blauer LED-Chip ist und der rote LED-Chip, der grüne LED-Chip und der blaue LED-Chip jeweils ein nach oben gerichteter LED-Chip, ein Flip-LED-Chip oder ein vertikaler LED-Chip sind.

4. Vollfarben-COB-Vorrichtung nach Anspruch 1, ferner umfassend eine Gehäuseschicht, wobei die Gehäuseschicht so konfiguriert ist, dass sie den lichtemittierenden Bereich abdeckt.

## Revendications

1. Dispositif à puce sur carte (COB) polychrome, comprenant un substrat (1), dans lequel une région électroluminescente est prévue sur une surface supérieure du substrat (1), la région électroluminescente comprend une région électroluminescente blanche (101) et une région d'éclairage d'ambiance (102), et la région d'éclairage d'ambiance (102) est une structure en forme d'anneau fermé ; et une pluralité de modules électroluminescents rouges (13), une pluralité de modules électroluminescents verts (14) et une pluralité de modules électroluminescents bleus (15) sont disposés dans la région d'éclairage d'ambiance (102), dans lequel la région électroluminescente blanche (101) n'est qu'une seule région électroluminescente blanche (101) et
la région d'éclairage d'ambiance (102) n'est qu'une région d'éclairage d'ambiance (102); la seule région d'éclairage d'ambiance (102) entoure la seule région électroluminescente blanche (101) ; et les modules électroluminescents rouges (13), les modules électroluminescents verts (14) et les modules électroluminescents bleus (15) sont disposés en quinconce de manière à garantir que la lumière émise par la seule région d'éclairage d'ambiance (102) soit uniformément mélangée en couleurs,
une pluralité de modules électroluminescents chauds (11) et une pluralité de modules électroluminescents froids (12) sont disposés dans la seule région électroluminescente blanche (101), et les modules électroluminescents chauds (11) et les modules électroluminescents froids (12) sont disposés en quinconce pour améliorer l'effet de mélange de lumière froide et de lumière chaude,
chaque module électroluminescent chaud (11) est une puce de boîtier à échelle de puce (CSP) à basse température de couleur et une plage de température de couleur de la puce CSP à basse température de couleur est 1800K à 3500K, et
chaque module électroluminescent froid (12) est une puce CSP à température de couleur élevée, une température de couleur de la puce CSP à température de couleur élevée est supérieure à celle de la puce CSP à température de couleur basse, et une plage de température de couleur de la puce CSP à température de couleur élevée est 3000K à 8000K, ou
chaque module électroluminescent froid (12) comprend une puce de diode électroluminescente (LED) et une couche de colle fluorescente et la couche de colle fluorescente recouvre un dessus de la puce de LED,
dans lequel la couche de colle fluorescente est un mélange de gel de silice et de phosphore, une température de couleur du phosphore est supérieure à celle de la puce CSP à basse température de couleur et une plage de température de couleur du phosphore est de 3000K à 8000K, et
un barrage (16) dépasse en saillie depuis la surface supérieure du substrat (1) et le barrage (16) est situé entre la seule région électroluminescente blanche (101) et la seule région d'éclairage d'ambiance (102) pour séparer efficacement la seule région émettrice de lumière blanche (101) provenant de la seule région d'éclairage d'ambiance (102).

2. Dispositif COB polychrome selon la revendication 1, dans lequel une zone de la région électroluminescente blanche (101) occupe 15% à 70% de celle de la zone électroluminescente selon un pourcentage de surface.

3. Dispositif COB polychrome selon la revendication 1, dans lequel chaque module électroluminescent rouge (13) est une puce LED rouge, chaque module électroluminescent vert (14) est une puce LED verte, chaque module électroluminescent bleu (15) est une puce LED bleue, et la puce LED rouge, la puce LED verte et la puce LED bleue sont chacune une d'une puce LED face vers le haut, d'une puce LED retournée ou d'une puce LED verticale.

4. Dispositif COB polychrome selon la revendication 1, comprenant en outre une couche de boîtier, dans lequel la couche d'emballage est configurée pour couvrir la région électroluminescente.
